# EUROPEAN PATENT SPECIFICATION

(11) **EP 0 320 405 B1**
(45) Date of publication and mention of the grant of the patent: **07.09.1994**
(21) Application number: 88403146.9
(22) Date of filing: 09.12.1988
(51) Int. Cl.: G11C 11/412, H01L 27/11

(54) **Semiconductor static random access memory device**
Statische Direktzugriffshalbleiterspeicheranordnung
Dispositif de mémoire à semi-conducteurs statique à accès aléatoire

(30) Priority: 09.12.1987 JP 311578/87
(43) Date of publication of application: 14.06.1989
(73) Proprietor: FUJITSU LIMITED, Kawasaki-shi, Kanagawa 211 (JP)
(72) Inventor: Ema, Taiji, Kawasaki-shi Kanagawa 213 (JP)
(74) Representative: Joly, Jean-Jacques

(56) References cited:
- EP-A- 0 080 730
- JP-A-62 210 666
- US-A- 4 453 175
- PATENT ABSTRACTS OF JAPAN vol. 11, no. 11 (E-470)(2458) 13 January 1987,& JP-A-61 185964
- SYMPOSIUM ON VLSI TECHNOLOGY May 1987, KARUIZAWA, JAPAN pages 101 - 102; T.YAMANAKA et al.: "A FOLDED RESISTOR AND CAPACITOR (FRC) STATIC MEMORY CELL WITHTRIPLE POLY-SI STRUCTURES"
- PATENT ABSTRACTS OF JAPAN vol. 12, no. 69 (E-587)(2916) 03 March 1988,& JP-A-62 210666

## Description

The present invention relates to a semiconductor random access memory device ; more precisely it relates to a structure of device forming load resistances which are used in each memory cell.

Static random access memory (SRAM) devices comprise a plurality of memory cells, each composed of a pair of inverters which include a field effect transistor (FET) and its load. FETs or resistors are generally used for the load of the inverter, however, in recent high packing density memory devices, the use of resistors is becoming more current for the load of the inverter, because the resistor can be formed over the FET which uses it as a load. This has the merit of decreasing the surface area of each unit cell and increasing the packing density of the memory cells in the device.

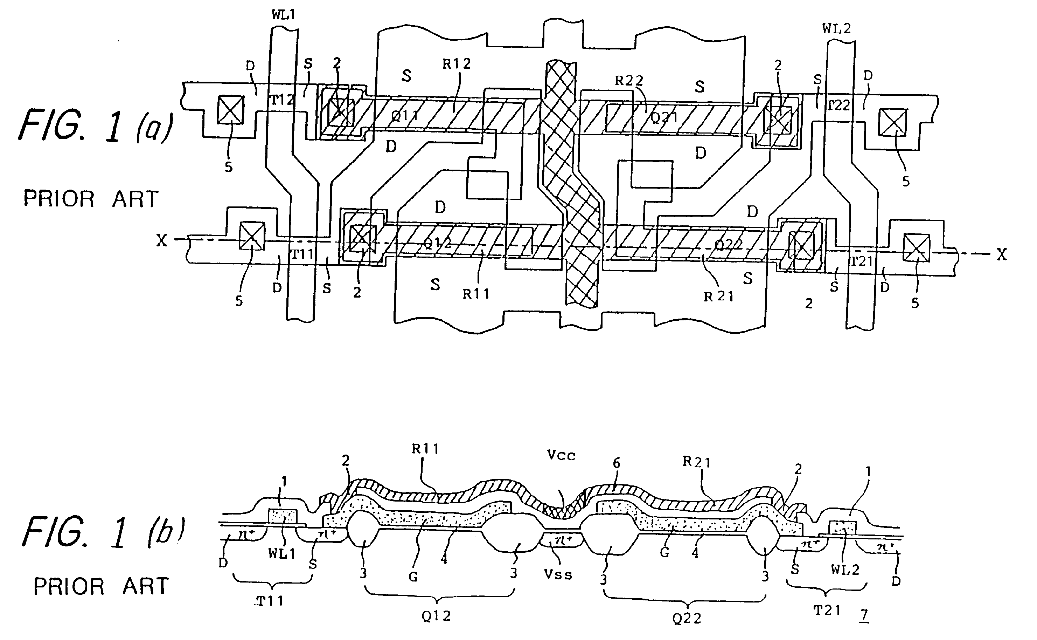

An exemplary figuration of a resistance loaded memory cell is shown in Fig. 1. Fig. 1(a) is a schematic plan view illustrating the arrangement of the electrodes and wiring of a memory cell pair. The left and right halves of the drawing respectively show a standard memory cell. Fig. 1(b) is a schematic cross sectional view of the device cut along the chained line XX in Fig. 1(a). In the figure, reference characters S and D designate respectively source and drain regions of the FETs. Gate electrodes G of inverter FETs Q11, Q12, Q21, Q22 run horizontally between the source region S and drain region D in Fig. 1(a). These gates, not shown in Fig. 1(a), can be seen in Fig. 1(b). The load resistors R11, R12, R21 and R22 are formed over the gate electrodes G, and are separated from the gate electrodes G by an insulation layer 1. One end of each of these load resistances is connected to a respective gate electrode G through respective gate contact holes 2. The reference numeral 3 designates field oxide layers which separate the devices from each other. The gate electrodes G are formed over respective gate oxide layers 4.

In Fig. 1(b), the source and drain regions of the FETs Q12 and Q22 cannot be seen, the cross section being taken along a plane cutting the device just along the gate G, but a typical FET cross section can be seen at transfer transistors T11 and T12 which are located on either side. The gates of these transfer transistors are respectively coupled to word lines WL1 and WL2, and their drains D are connected to bit lines (not shown) through drain contact holes 5 to convey the data stored in the cell to outer circuit. Respective portions of the word lines WL1 and WL2 crossing the transfer transistors T11, T12, T21 and T22 become their gate electrodes, as shown in the figures. A voltage source line Vss is formed in the substrate 7 by diffusion and buried between the field oxide layers 3, while another source line Vcc as well as resistors are formed over the surface of the insulation layer 1. The resistors R and Vcc lines show in Fig. 1(a) are formed and patterned simultaneously and in same fabrication steps.

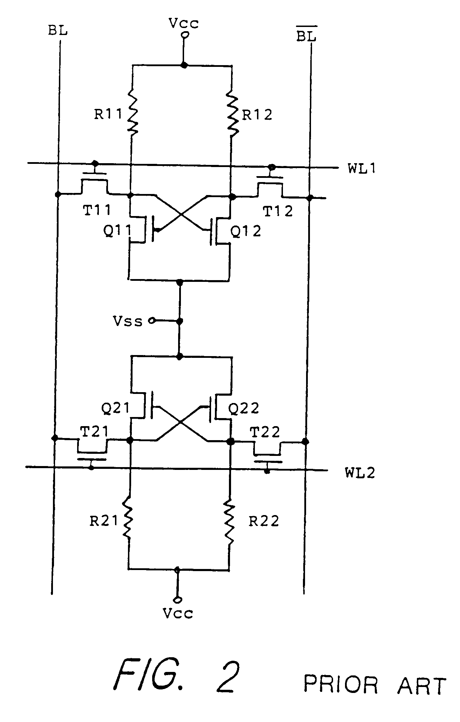

An equivalent circuit diagram of the device of Fig. 1 is shown in Fig. 2. The upper and lower halves of the circuit respectively represent a unit memory cell corresponding to the left and right halves of Fig. 1(a). Each of the unit cells is composed of a pair of inverters forming a flip flop circuit. Each memory cell includes four FETs, such as Q11, Q12, T11 and T12 for example, and two load resistors R11, R12. When a word line such as WL1 is selected, the transfer transistor T11 or T12 conveys the state information that Q11 or Q12 is in high level to a sense amplifier (not shown) via the bit lines BL or B̅L̅. So, the memory is read out.

As can be seen in Figs. 1(a) and 1(b), the load resistors (R11, R12 etc.) of the memory cell can be fabricated over the inverter FETs (Q11, Q12, etc.). Thus, the area of the unit cell can be made smaller than a circuit using FETs as the load of the inverters. This is the main reason that recent SRAMs use resistance load for the flip flop circuits. But as the packing density becomes high, the following problems became apparent.

In order to make the packing density as high as possible, a size of unit cell as small as possible is desirable, at the same time it is desirable to make the value of the resistance of the load resistors as high as possible, because high resistance decreases the problem of power consumption. Practically, the size of the memory cells having a structure like Fig. 1 is limited by the fabrication technique of the load resistors, whereas the size of the transistors could be reduced still further.

For example, the resistance of the load resistors is required to be about 10¹² ohms, and current running through the resistors at 5 volts is a few picoamperes. A material actually used for fabricating such a high resistance for semiconductor devices is polysilicon (polycrystalline silicon). The dimensions of the load resistor used for a 1 Mbit SRAM, for example, are about 1 µm width, 3 µm length and 200 nm thickness. Compared to this size, the area occupied by the FET can be further reduced by advances in photolithography. However, the length of the load resistor cannot be reduced, for the following reasons.

Generally, if resistance per unit length of the load resistors is increased, the size of the resistor can be decreased. In order to increase the resistance, however, the resistivity of the polysilicon must be increased, the thickness and the width of the resistor must be decreased, or the length of the resistor must be increased. But the resistivity of the polysilicon cannot be sufficiently increased because the impurity concentration in the polysilicon cannot be further reduced due to purity limitation of the material.

Neither can the thickness of the resistor be sufficiently reduced. This is due to the design of the device. As can be seen in Fig. 1, the polysilicon layer 6 is used for load resistors R11 etc.

At the same time, the same polysilicon layer 6 is used for fabricating the Vcc line, the resistance of which is desired to be as low as possible. In order to decrease the resistance of the Vcc line, the portion of the Vcc line in the polysilicon layer 6 is ion implanted to increase its conductivity. But the conductivity of a thin polysilicon layer cannot be increased sufficiently, because excessively high doping of ion implantation causes a migration or diffusion of impurity in the lateral direction from the Vcc line. This causes a decrease in the resistance of the load resistor which is connected to the Vcc line. Therefore, some length (3 µm for example) of the load resistor is necessary.

Further, though it is not shown in the figure, other portions of the polysilicon layer 6 are patterned in various ways and utilized for fabricating other parts of the device, such as fuse elements, which is inevitable for such a high density memory device to increase the production yield. A protection circuit for protecting the device from unexpected high voltage surges is also fabricated using the same polysilicon layer 6. These devices all require different conductivity levels of the polysilicon layer 6. In order to be able to meet these requirements, the thicker polysilicon layer is desirable for these parts.

The width of the resistor as well as the size of other elemental devices might be decreased by progress in photolithography ; thus, it may be considered that the length of the load resistor can be cut down. But still another difficulty arises. A resistor having a very high resistance value requires a certain length ; the value of 10¹² ohms and 3 µm length was given in the example above. Too short a length for a high resistance value causes instability due to surface instability and impurity diffusion. In the case of Fig. 1, both ends of the load resistor are contacted with high impurity regions, the Vcc line and the gate electrode. The impurity, especially that of the Vcc line, causes diffusion into the load resistor and decreases the effective length of the resistor.

It will be understood from Fig. 1(a) that the length of the resistors is already designed to the maximum length allowable in a unit cell. The resistors are extended over the full distance between the Vcc line and the gate contact hole 2 which is located at the opposite end of the inverter transistor Q. Further increase of the length causes an unnecessary elongation of the transistor Q, and decreases the packing density. Therefore, in order to fabricate a memory device having a further increased memory size, an increase of the size of the memory device is indispensable.

Efforts to increase the packing density in LSI circuits (large scale integrated circuits) are continued in every field of the semiconductor technology, especially in photolithographic technology. Even though photolithography is improved and the patterns of elemental devices are made smaller, the size of the SRAM is limited by the length of the load resistors, for the reason described above.

If the length and hence the resistance of the load resistors over a unit cell could be increased, the size of the unit cell could be reduced by cutting the length of the load resistors down to compensate the increased resistance value, further reduction in the size of the inverter FETs being possible and a higher packing density could be realized.

For an example of a prior art semiconductor corresponding to the preamble of claim 1, reference can be made to document JP-A-61 185 964.

The object of the present invention, therefore, is to provide a SRAM with a memory cell structure which enables an increase in the length and resistance of load resistors formed over the unit cells.

Another object of the present invention is to cut down the size of the unit cells, and to increase the packing density of SRAM devices.

A further object of the present invention is to realize a SRAM device of which the memory size is many times larger than those of the prior art devices.

To achieve the foregoing objects, the present invention provides a SRAM formed on a semiconductor substrate with a plurality of insulation layers formed over said semiconductor substrate, said SRAM comprising a plurality of unit cell pairs, each of said unit cell pairs being composed of a first unit cell and a second unit cell, said first unit cell and second unit cell respectively comprising a flip flop circuit which is formed by a pair of resistor loaded inverters, each of said resistor loaded inverters comprising an inverter transistor composed of a FET formed in said substrate and a load resistor, wherein the first load resistors for said first unit cell and the second load resistors for said second unit cell have a respective layer pattern extending over a substrate surface of an adjacent unit cell within each of said unit cell pairs, characterized in that said first load resistors and said second load resistors are formed on different insulation layers.

Thus each of the resistors can be extended over the adjoining unit cell utilizing the full length of the neighbouring unit cell. Therefore, the resistance of each resistor can be easily increased to more than twice the value of the prior art resistors.

By adopting such configuration, the number of process steps for fabricating the device are increased to some extent, but the advantages obtained by such structure outstrip the demerits. If the same resistance value is used, the length of the load resistor can be decreased to 1/2 that of the prior art. This means that the limit of size reduction of SRAM devices caused by the length of the load resistor has been removed. As long as the size of elemental devices can be reduced, the packing density of the SRAM can be increased by four ; that is to say, a device having four times as large a memory capacity can be realized without an increase in size.

Extending such consideration, it is possible to further improve the device. Namely, if still other polysilicon layers are added to separate the Vcc line from the layers of load resistors, the fabrication of thicker Vcc lines and thinner load resistors compared to the respective counterparts of prior art devices would be possible. The other parts of the device such as fuse and protection circuits can be fabricated in the thicker layer, and the problems described above can be completely traversed.

These and other advantages of the present invention will be discussed in more detail in a following description of the preferred embodiments in which reference is made to accompanying drawings.

Fig. 1 shows the structure of memory cells of a typical resistance loaded SRAM, wherein :
Fig. 1(a) is a schematic plan view illustrating the arrangement of the electrodes and wiring of a memory cell pair ; and
Fig. 1(b) is a schematic cross sectional view of the device cut along the chained line XX in Fig. 1(a).

Fig. 2 is an equivalent circuit diagram of the memory cells of Fig. 1.

Fig. 3 shows a pair of memory cells of an SRAM illustrating a first embodiment of the present invention, wherein :
Fig. 3(a) is a schematic plan view illustrating the arrangement of the electrodes and wiring of a memory cell pair ; and
Fig. 3(b) is a schematic cross sectional view of the device cut along the chained line XX in Fig. 3(a).

Fig. 4(a) through Fig. 4(h) are cross sectional diagrams illustrating major steps of the fabrication process for the device of Fig. 3.

Fig. 5 illustrates a second embodiment of the present invention in which the Vcc lines are separated from the resistance layers, wherein :
Fig. 5(a) is a schematic plan view illustrating the arrangement of the electrodes and wiring of a memory cell pair ; and
Fig. 5(b) is a schematic cross sectional view of the device cut along the chained line XX in Fig. 5(a).

Fig. 6 shows a cross section of a third embodiment of the present invention, which is a modification of the first embodiment of Fig. 3 to further elongate the length of the resistor.

Throughout the drawings, similar or like reference characters designate same parts or corresponding parts.

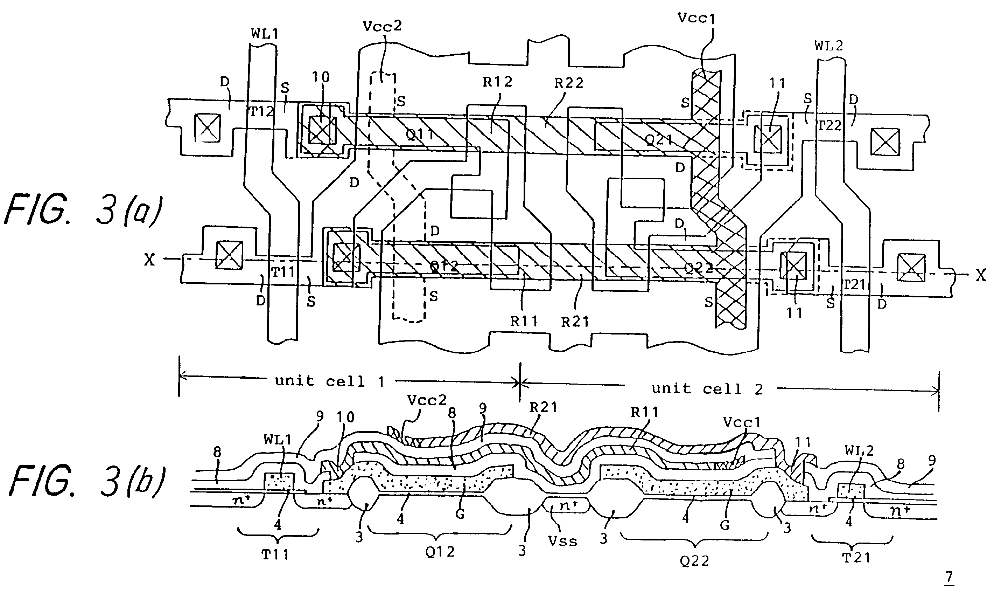

Fig. 3(a) is a schematic plan view illustrating the arrangement of elemental devices and wiring for a pair of memory cells for an SRAM comprising a first embodiment of the present invention. Fig. 3(b) shows schematically a cross section of the device of Fig. 3(a) cut along the chained line XX in Fig. 3(a). The left and right halves of the figure show respectively a unit cell 1 and a unit cell 2, which are paired to one another. Compared to the prior art device of Fig.1, it will be noticed that the arrangement of the FETs in substrate 7 is similar to that of the prior art. But the arrangement of the load resistors and voltage source line Vcc is different. In the device of Fig. 1, the load resistors and the Vcc line are formed on a single insulation layer 1, whereas in the embodiment of Fig. 3, the load resistors and the Vcc line for the unit cell 1, and those for the unit cell 2 are formed on different insulation layers, and stacked one upon the other forming a double layer.

The load resistors R11 and R12 for the inverter transistors Q11 and Q12 of the unit cell 1 are formed on a first insulation layer 8 which covers the entire surface of the device. Vcc1, the voltage source line for the unit cell 1 is also formed on the first insulation layer 8. The entire surface of these elemental devices, as well as transfer transistors T11 - T22, are coated by a second insulation layer 9. The load resistors R21, R22 and a second voltage source line Vcc2 for the inverter transistors Q21 and Q22 of the unit cell 2 are formed on the second insulation layer 9. The load resistors R11 and R12 are connected respectively to the gate electrodes G of Q11 and Q12 through first contact holes 10. In Fig. 3(a), parts of the load resistors R21, R22 and the Vcc2 line, formed on the second insulation layer 9, are indicated by broken lines, to distinguish them from those formed on the first insulation layer 8.

Since the load resistors and Vcc lines for the unit cell 1 and unit cell 2 are formed on separate layers, and these layers are stacked one upon the other, it will be apparent that the pattern of the load resistors can be extended over the entire length of neighbouring unit cell. Accordingly, compared to Fig. 1, the length of the load resistors R11 - R22 stretch over a length twice that of the prior art load resistors. This means that the resistance value of each load resistor is doubled using the same fabrication technology and tolerance. Therefore, if the resistance of these load resistors is equal to that of those of Fig. 1, the length of the load resistors R11 - R22 of Fig. 3 can be cut down to 1/2 of the length shown in the figure.

Therefore, as long as the progress of photolithography allows reduction in the size of other elemental devices, the size of the SRAM device can be cut down. If the size of these devices is decreased by 1/2 to meet the shortened load resistors, the packing density of the SRAM is increased by four to that of the prior art, or a device having four times as large a memory capacity can be realized without increasing the size of the SRAM.

Next, a production process for the first embodiment will be described briefly, in order to further clarify the structure of the device object of the present invention. Since the process steps used for production of this embodiment are all conventional ones, and they are not explicitly relevant to the invention, the process as a whole will be described briefly. Of course, various modifications are possible in the process as well as the materials, the invention not being restricted to those which will be disclosed hereinafter.

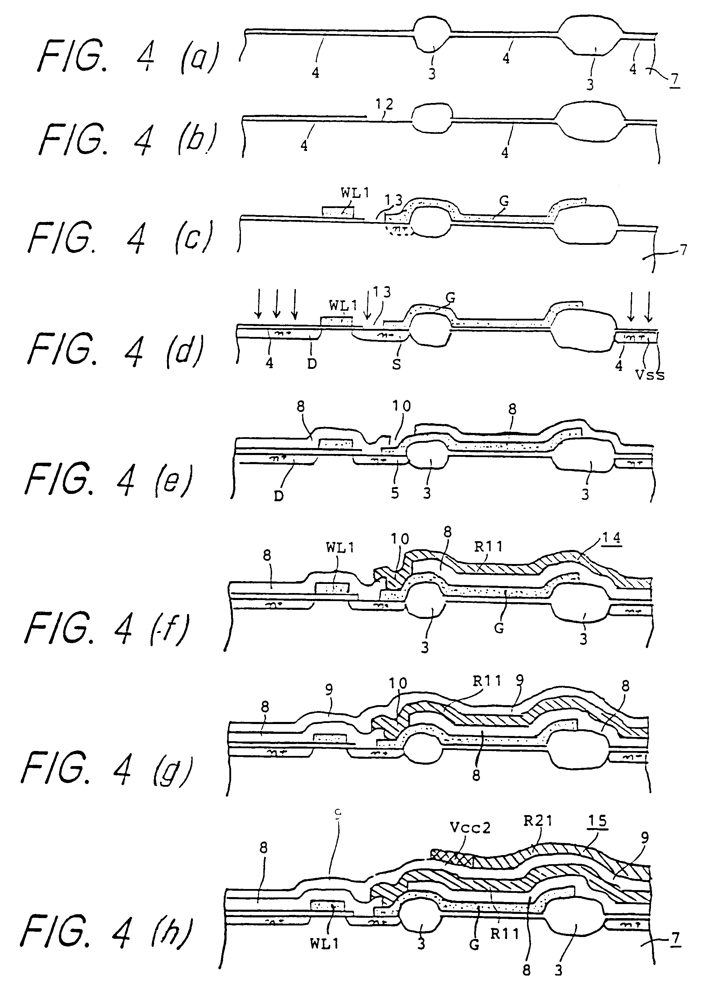

Figs. 4(a) through (h) show schematically how a cross section of the unit cell 1 varies at major steps of the fabrication process. The figures show the left half of a cross section taken along the chained line XX in Fig. 3(b). First, as shown in Fig. 4(a), a substrate 7 is selectively oxidized by applying photolithography to form field oxide layers 3 and gate oxide layers 4. The former separate the elemental devices to be formed in the substrate 7 from one another, and the latter insulate the gate electrodes from the substrate 7. The gate oxide layer 4 is patterned to open a window 12 by photolithography as shown in Fig. 4(b).

Next, as shown in Fig. 4(c), a first n+ doped polysilicon layer (identified by dots in the figure) of about 400 nm thick is deposited by chemical vapor deposition (CVD) over the entire surface of the substrate, and patterned to form a word line WL1, a gate electrode G and an opening 13 by photolithography. At this time, a portion of the substrate directly contacting the gate electrode G is doped by n type impurity diffused from the first polysilicon layer, as shown by broken line in Fig. 4(c). Next n type impurity is ion implanted through the gate oxide layer 4 and the opening 13. By annealing n+ regions including drain region D, source region S and Vss line are formed in the substrate as shown in Fig. 4(d). The portion beneath the word line WL1 becomes channel region of the transfer transistor T11, and the corresponding portion of the WLI becomes gate electrode of T11 (see Fig. 3).

Next, as shown in Fig. 4(e), a silicon dioxide (SiO₂) layer of about 100 nm thickness is formed over the substrate, and first contact holes 10 are opened. This SiO₂ layer becomes the first insulation layer 8.

Subsequently, as shown in Fig. 4(f), over the first insulation layer 8 is deposited by CVD a first non doped polysilicon layer 14 of 100-150 nm thickness. At the right hand side edge (not shown) of the first non doped polysilicon layer 14 is selectively ion implanted the first voltage source line Vcc1 (see Fig. 3(b)). Then the polysilicon layer 14 is patterned to form the load resistors R11 and R12 (not shown). The load resistors R11 and R12 are contacted at one end to the gate electrode G through the first contact holes 10. The other ends (not shown) of the load resistors R11 and R12 are connected to the Vcc1 line as shown in Fig. 3(b).

Next, as shown in Fig. 4(g), the entire surface is coated by the second insulation layer 9, which is a SiO₂ layer of about 100 nm thickness deposited by CVD. In the second insulation layer 9 are formed second contact holes 11 (see Fig. 3). The second contact holes 11 penetrate through the first insulation layer 8, and reach to the gate electrodes G of the FETs Q21, Q22 which belong to the unit cell 2 as shown in Fig. 3.

Over the second insulation layer 9, is deposited by CVD a second non doped polysilicon layer 15 of 100 - 150 nm thickness. The left hand side edge portion of the second non doped polysilicon layer 15 is selectively ion implanted to form the second Vcc line Vcc2 as shown in Fig. 4(h). And the second polysilicon layer 15 is patterned to form the load resistors R21 and R22 (not shown). The load resistors R21 and R22 are connected at their left ends to the Vcc2 line, while their respective opposite ends (not shown) are connected through the second contact holes 11 to the gate electrodes G of the FET Q21 and Q22, which belong to unit cell 2 as shown in Fig. 3(b).

In such a manner, a pair of unit cells are fabricated. Subsequent steps required to complete the SRAM device are common ones, namely forming a passivation layer over the device and forming a wiring layer on it. Description for these steps are omitted for the sake of simplicity.

From the above disclosure, it will be apparent that the load resistors and Vcc lines for the unit cell 1 are formed on the first insulation layer 8, and these elements for the unit cell 2 are formed on the second insulation layer 9, and are separated from each other. The following points should be further noted. The load resistances for the inverter pair of the flip flop circuit of the SRAM should be balanced to each other as precisely as possible. The load resistors for the unit cell 1 and unit cell 2 of this embodiment are formed on a same layer (8 or 9) at the same production process step ; accordingly, the resistance values of the resistors on the same layer are made very close to each other, insuring that the balance of the resistance is very good.

Further, the increased length of the load resistor provides a supplemental advantage. As has been described, the effective length of the load resistor is decreased by diffusion or migration of impurities from the Vcc line, which is connected to one end of the load resistors. A similar reduction in length occurs even when the load resistor length is increased as indicated above. Therefore, if the load resistor length is doubled, the effective length of the resistor is more than doubled. For example, if the diffusion length of the impurities is 0.5 µm, the effective length of a 3 µm long resistor is reduced to 2.5 µm, whereas the effective length of a 6 µm long resistor will be 5.5 µm or 2.2 times longer than the previous length.

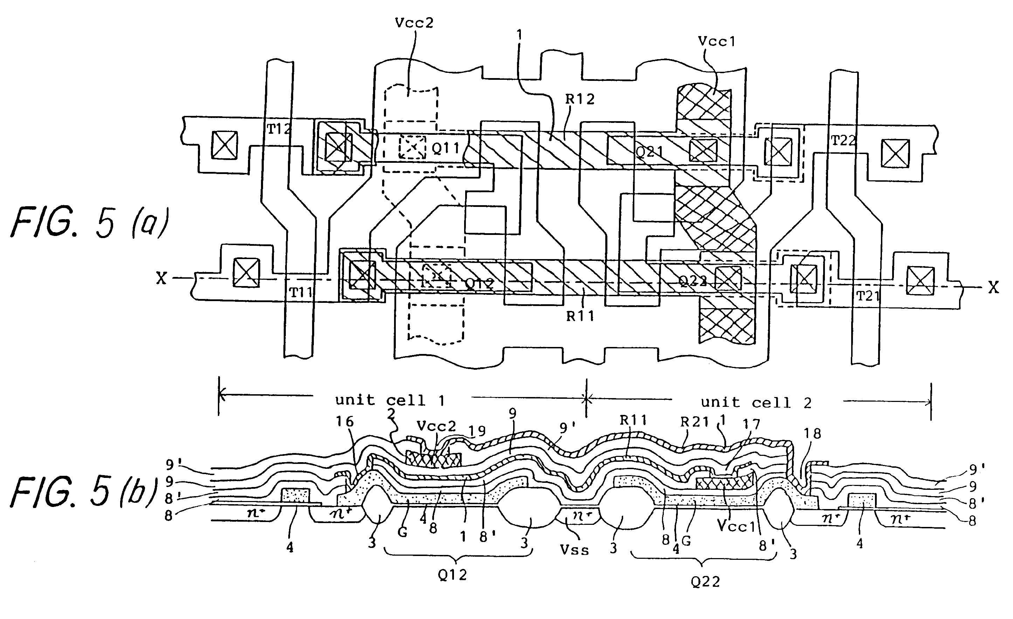

Fig. 5 shows a second embodiment of the present invention. A plan view of the device is given in Fig. 5(a) showing an arrangement of elemental devices, and a cross section is shown in Fig. 5(b). Compared to Fig. 3(a), it will be noticed that the arrangement of the elemental devices on the substrate is similar. But, from a cross section of the device shown in Fig. 5(b), it will be clear that the voltage source lines Vcc1 and Vcc2 are formed in different layers from those of the load resistors R11, R12 and R21, R22. In Fig. 5(a), parts of the load resistors R21, R22 and the voltage source line Vcc2 which belong to the unit cell 2 are indicated by broken lines, to distinguish them from those counterparts which belong to the unit cell 1.

Fig. 5(b) shows a cross section along the chained line XX in Fig. 5(a). The layers corresponding to the first insulation layer 8 and the second insulation layer 9 of Fig. 3(b) are respectively divided into double layers 8, 8′ and 9, 9′. The voltage source line Vcc1 is formed on the first insulation layer 8, and covered with a third insulation layer 8′. The load resistors R11 and R12 for the FETs Q11 and Q12 of the unit cell 1 are formed on the third insulation layer 8′, and their left sides contact respectively to the gate electrodes G of Q11 and Q12 through first contact holes 16, formed through the first insulation layer 8 and the third insulation layer 8′, while the right sides of the load resistors R11 and R12 contact Vcc1 through third contact holes 17 formed on the third insulation layer 8′. The unit cell 1 and the transfer transistors T21, T22 are covered with the second insulation layer 9. Similarly, the voltage source line Vcc2 for the unit cell 2 is formed on the second insulation layer 9, and covered with a fourth insulation layer 9′. The load resistors R21 and R22 for the FETs Q21 and Q22 of the unit cell 2 are formed on the fourth insulation layer 9′, and their right sides contact respectively to the gate electrodes G of Q21 and Q22 through second contact holes 18 formed through the four insulation layers 8, 8′, 9, 9′, while the left sides of the load resistors R21 and R22 contact respectively the Vcc2 line through fourth contact holes 19 formed through the fourth insulation layer 9′.

By adopting such configuration, it becomes possible to increase the design thickness of the Vcc1 and Vcc2 lines, and the conductivity of polysilicon layer beyond that of the load resistors R11 - R22, because the voltage source lines Vcc1 and Vcc2 are formed in separate layers from the layers forming the load resistors. The width of the Vcc lines also can be increased. Thus, the resistance of the voltage source lines is significantly decreased compared to that of the first embodiment. This increases the operation speed of the device. On the other hand the layers of the load resistors can be made more thin, 20 nm for example. This extends the possibility to further increase the load resistance, and hence to further reduce the unit cell size. Further, the effect of migration of the impurity is perfectly eliminated.

The thick layer of polysilicon for the Vcc lines can be utilized for fabricating other parts of the memory device. For example, fuse circuits are inevitable for large scale integrated circuits (LSI circuits), to cut off a failed part of circuit from the main circuit and switch in a prefabricated redundant circuit. By such circuit, the yield of LSI circuits is increased. Surge protection circuits also may be fabricated using the thick polysilicon layer. These circuits are difficult to form in a very thin polysilicon layer ; hence the second embodiment provides a device with a layer convenient for fabricating these circuits. This is another merit of the second embodiment.

The process for fabrication the second embodiment will be easily appreciated by the one skilled in the art as a minor change of the process for fabricating the first embodiment. To describe the process steps briefly, each of the steps or processes corresponding to like steps of Fig. 4 will be called step (a), (b) ... or process (a), (b) ... hereinafter. In the step (f), the first non doped polysilicon layer 14 is deposited thicker than that of the first embodiment, 200 nm thick for example, and patterned to form Vcc1 line (see Fig. 5). The Vcc1 line may be ion implanted or the polysilicon layer may be doped to give it sufficient conductivity. Then the third insulation layer 8′ of SiO₂ is deposited by CVD in a manner similar to step (f), and the step (f) is repeated to form R11 and R12. Similar processes are repeated for the unit cell 2 at the step (h).

By separating the layer of the load resistors from other parts of the device as in the second embodiment, the material of the load resistors can be changed from polysilicon to other materials, such as silicon carbide (SiC), amorphous silicon, molybdenum alloy and so on. This further increases design choice.

It will be understood that such a structure of separated layers for the load resistances of separated Vcc lines may be applied directly to the prior art structure of Fig. 1. For example, the load resistors R11 - R22 may be formed on another layer. But the effect of the separated layer is more apparent when applied to separate R11, R12 from R21, R22 such as in the second embodiment.

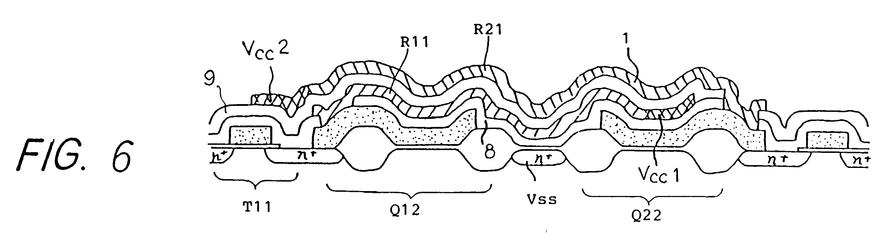

Fig. 6 shows a cross section of a third embodiment of the present invention. The figure shows corresponding parts of Fig. 3(b). Comparing Fig. 6 with Fig. 3(b), it can be seen that the Vcc2 line is formed over the inverter FETs Q12 and Q22 in the first embodiment, whereas in the third embodiment, it is formed over the transfer transistors T11 and T12. This enables to further elongate the load resistors R21 and R22 more than those of the first embodiment.

The third embodiment may be considered as a modification of the first embodiment. However, the elongation of R21 and R22 implies a higher resistance. Thus, the thickness of the second non doped polysilicon layer 15 (Fig. 4(h)) may be increased to compensate the increase of the resistance. This makes it easier to decrease the resistivity of the polysilicon layer used for fuse or protection circuits. The balance of the load resistors for each inverter pair of the flip flop circuit is maintained, because the load resistors for the pair of FETs are fabricated on the same layer in the same process step.

As has been described above, the present invention permits an increase in the resistance of load resistors for flip flop circuits in SRAM devices, so that the size of the unit cells can be reduced, and the packing density of the device increased.

## Claims

1. A semiconductor static random access memory device (SRAM) formed on a semiconductor substrate (7) with a plurality of insulation layers formed over said semiconductor substrate, said SRAM comprising a plurality of unit cell pairs, each of said unit cell pairs being composed of a first unit cell (1) and a second unit cell (2), said first unit cell and second unit cell respectively comprising a flip flop circuit which is formed by a pair of resistor loaded inverters, each of said resistor loaded inverters comprising an inverter transistor (Q11, Q12, Q21, Q22) composed of a field effect transistor (FET) formed in said substrate and a load resistor (R11, R12, R21, R22), wherein the first load resistors (R11, R12) for said first unit cell (1) and the second load resistors (R21, R22) for said second unit cell (2) have a respective layer pattern extending over a substrate surface of an adjacent unit cell within each of said unit cell pairs,
characterized in that said first load resistors (R11, R12) and said second load resistors (R21, R22) are formed on different insulation layers (8, 9).

2. A semiconductor static random access memory device as set forth in claim 1, in which :
each of said first unit cells (1) further comprises a first voltage source line (Vcc1) for supplying a source voltage to said first unit cell ; and
each of said second unit cells (2) further comprises a second voltage source line (Vcc2) for supplying a source voltage to said second unit cell,
wherein :
said first load resistors (R11, R12) of said first unit cell (1) and said first voltage source line (Vcc1) are formed on a first insulation layer (8) formed over said substrate (7) ; and
said second load resistors (R21, R22) of said second unit cell (2) and said second voltage source line (Vcc2) are formed on a second insulation layer (9) which is formed over said first insulation layer (8).

3. A semiconductor static random access memory device as set forth in claim 1, in which :
each of said first unit cells (1) further comprises a first voltage source line (Vcc1) for supplying a source voltage to said first unit cell, and
each of said second unit cells (2) further comprises a second voltage source line (Vcc2) for supplying a source voltage to said second unit cell,
wherein :
said first voltage source line (Vcc1) is formed on a first insulation layer (8), which is formed over said substrate (7) ;
said first load resistors (R11, R12) of said first unit cell (1) are formed on a third insulation layer (8′) which is formed over said first insulation layer (8) ;
said second voltage source line (Vcc2) is formed on a second insulation layer (9), which is formed over said third insulation layer (8′) ; and
said second load resistors (R21, R22) of said second unit cell (2) are formed on a fourth insulation layer (9′) which is formed over said second insulation layer (9).

4. A semiconductor static random access memory device as set forth in claim 2, in which each of said unit cells (1, 2) further comprises transfer transistors (T11, T12, T21, T22) each connected to a respective inverter transistor and composed of a FET formed in said substrate (7) and positioning in peripheral portion of said inverter transistors (Q11, Q12, Q21, Q22) for sending out an information whether said inverter is in high state or low state to an outer circuit, wherein :
the second load resistors (R21, R22) formed on said second insulation layer (9) are longer and thicker than the first load resistors (R11, R12) formed on said first insulation layer (8).

5. A semiconductor static random access memory device as set forth in claim 1, 2, 3 or 4, wherein said substrate (7) is a silicon substrate, and said insulation layers are silicon dioxide (SiO₂) layers.

6. A semiconductor static random access memory device as set forth in claim 1, 2, 3 or 4, wherein said first and second load resistors (R11, R12, R21, R22) and said voltage source lines (Vcc1, Vcc2) are made from polysilicon.

7. A semiconductor static random access memory device as set forth in claim 3 or 4, wherein the thickness of said load resistors is less than the thickness of said voltage source lines.

8. A semiconductor static random access memory device as set forth in claim 3, in which said first and second voltage source lines (Vcc1, Vcc2) are each formed from a polysilicon layer having a thickness greater than that of first and second load resistors (R11, R12, R21, R22), and
said SRAM further comprises a surge protection circuit formed from said polysilicon layer having a greater thickness.

9. A semiconductor static random access memory device as set forth in claim 1, in which :
a substantial part of the layer pattern of the second load resistors (R21, R22) is formed above the layer pattern of the first load resistors (R11, R12).

10. A semiconductor static random access memory device as set forth in claim 4, in which said second voltage source line (Vcc2) is formed from a polysilicon layer (15) used for forming said second load resistors (R21, R22), and
said SRAM further comprises a surge protection circuit formed from said polysilicon layer of said second voltage source line (Vcc2).

## Patentansprüche

1. Eine statische Halbleiterspeicheranordnung mit wahlfreiem Zugriff (SRAM), die auf einem Halbleitersubstrat (7) mit einer Vielzahl von Isolierschichten gebildet ist, die über dem genannten Halbleitersubstrat gebildet sind, welcher SRAM eine Vielzahl von Einheitszellenpaaren umfaßt, jedes der genannten Einheitszellenpaare aus einer ersten Einheitszelle (1) und einer zweiten Einheitszelle (2) besteht, welche erste Einheitszelle und zweite Einheitszelle jeweils eine Flipflop-Schaltung umfassen, die durch ein Paar von widerstandsbelasteten Invertern gebildet ist, jeder der genannten widerstandsbelasteten Inverter einen Invertertransistor (Q11, Q12, Q21, Q22) umfaßt, der aus einem Feldeffekttransistor (FET), der in dem genannten Substrat gebildet ist, und einem Lastwiderstand (R11, R12, R21, R22) besteht, bei der die ersten Lastwiderstände (R11, R12) für die genannte erste Einheitszelle (1) und die zweiten Lastwiderstände (R21, R22) für die genannte zweite Einheitszelle (2) ein jeweiliges Schichtmuster haben, das sich über eine Substratoberfläche einer angrenzenden Einheitszelle innerhalb jedes der genannten Einheitszellenpaare erstreckt,
dadurch gekennzeichnet, daß die genannten ersten Lastwiderstände (R11, R12) und die genannten zweiten Lastwiderstände (R21, R22) auf verschiedenen Isolierschichten (8, 9) gebildet sind.

2. Eine statische Halbleiterspeicheranordnung mit wahlfreiem Zugriff nach Anspruch 1, in der:
jede der genannten ersten Einheitszellen (1) ferner eine erste Spannungsquellenleitung (Vcc1) zum Zuführen einer Quellenspannung zu der genannten ersten Einheitszelle umfaßt; und
jede der genannten zweiten Einheitszellen (2) ferner eine zweite Spannungsquellenleitung (Vcc2) zum Zuführen einer Quellenspannung zu der genannten zweiten Einheitszelle umfaßt,
bei der:
die genannten ersten Lastwiderstände (R11, R12) der genannten ersten Einheitszelle (1) und die genannte erste Spannungsquellenleitung (Vcc1) auf einer ersten Isolierschicht (8) gebildet sind, die über dem genannten Substrat (7) gebildet ist; und
die genannten zweiten Lastwiderstände (R21, R22) der genannten zweiten Einheitszelle (2) und die genannte zweite Spannungsquellenleitung (Vcc2) auf einer zweiten Isolierschicht (9) gebildet sind, die über der genannten ersten Isolierschicht (8) gebildet ist.

3. Eine statische Halbleiterspeicheranordnung mit wahlfreiem Zugriff nach Anspruch 1, in der:
jede der genannten ersten Einheitszellen (1) ferner eine erste Spannungsquellenleitung (Vcc1) zum Zuführen einer Quellenspannung zu der genannten ersten Einheitszelle umfaßt, und
jede der genannten zweiten Einheitszellen (2) ferner eine zweite Spannungsquellenleitung (Vcc2) zum Zuführen einer Quellenspannung zu der genannten zweiten Einheitszelle umfaßt,
bei der:
die genannte erste Spannungsquellenleitung (Vcc1) auf einer ersten Isolierschicht (8) gebildet ist, die über dem genannten Substrat (7) gebildet ist;
die genannten ersten Lastwiderstände (R11, R12) der genannten ersten Einheitszelle (1) auf einer dritten Isolierschicht (8′) gebildet sind, die über der genannten ersten Isolierschicht (8) gebildet ist;
die genannte zweite Spannungsquellenleitung (Vcc2) auf einer zweiten Isolierschicht (9) gebildet ist, die über der genannten dritten Isolierschicht (8′) gebildet ist; und
die genannten zweiten Lastwiderstände (R21, R22) der genannten zweiten Einheitszelle (2) auf einer vierten Isolierschicht (9′) gebildet sind, die über der genannten zweiten Isolierschicht (9) gebildet ist.

4. Eine statische Halbleiterspeicheranordnung mit wahlfreiem Zugriff nach Anspruch 2, in der jede der genannten Einheitszellen (1, 2) ferner Transfertransistoren (T11, T12, T21, T22) umfaßt, die jeweils mit einem entsprechenden Invertertransistor verbunden sind und aus einem FET bestehen, der in dem genannten Substrat (7) gebildet ist und im peripheren Abschnitt der genannten Invertertransistoren (Q11, Q12, Q21, Q22) positioniert ist, zum Aussenden von Informationen darüber, ob der genannte Inverter in einem hohen Zustand oder niedrigen Zustand ist, an eine äußere Schaltung, bei der:
die zweiten Lastwiderstände (R21, R22), die auf der genannten zweiten Isolierschicht (9) gebildet sind, länger und dicker als die ersten Lastwiderstände (R11, R12) sind, die auf der genannten ersten Isolierschicht (8) gebildet sind.

5. Eine statische Halbleiterspeicheranordnung mit wahlfreiem Zugriff nach Anspruch 1, 2, 3 oder 4, bei der das genannte Substrat (7) ein Siliziumsubstrat ist und die genannten Isolierschichten Siliziumdioxid-(SiO₂)-Schichten sind.

6. Eine statische Halbleiterspeicheranordnung mit wahlfreiem Zugriff nach Anspruch 1, 2, 3 oder 4, bei der die genannten ersten und zweiten Lastwiderstände (R11, R12, R21, R22) und die genannten Spannungsquellenleitungen (Vcc1, Vcc2) aus Polysilizium hergestellt sind.

7. Eine statische Halbleiterspeicheranordnung mit wahlfreiem Zugriff nach Anspruch 3 oder 4, bei der die Dicke der genannten Lastwiderstände kleiner als die Dicke der genannten Spannungsquellenleitungen ist.

8. Eine statische Halbleiterspeicheranordnung mit wahlfreiem Zugriff nach Anspruch 3, in der die genannten ersten und zweiten Spannungsquellenleitungen (Vcc1, Vcc2) jeweils aus einer Polysiliziumschicht gebildet sind, die eine Dicke hat, die größer als jene der ersten und zweiten Lastwiderstände (R11, R12, R21, R22) ist, und
der genannte SRAM ferner eine Überspannungsschutzschaltung umfaßt, die aus der genannten Polysiliziumschicht gebildet ist, die eine größere Dicke hat.

9. Eine statische Halbleiterspeicheranordnung mit wahlfreiem Zugriff nach Anspruch 1, in der:
ein wesentlicher Teil des Schichtmusters der zweiten Lastwiderstände (R21, R22) über dem Schichtmuster der ersten Lastwiderstände (R11, R12) gebildet ist.

10. Eine statische Halbleiterspeicheranordnung mit wahlfreiem Zugriff nach Anspruch 4, in der die genannte zweite Spannungsquellenleitung (Vcc2) aus einer Polysiliziumschicht (15) gebildet ist, die zum Bilden der genannten zweiten Lastwiderstände (R21, R22) verwendet wird, und
der genannte SRAM ferner eine Überspannungsschutzschaltung umfaßt, die aus der genannten Polysiliziumschicht der genannten zweiten Spannungsquellenleitung (Vcc2) gebildet ist.

## Revendications

1. Dispositif de mémorisation à accès direct statique à semiconducteur (SRAM) formé sur un substrat semiconducteur (7) avec plusieurs couches d'isolation formées sur ledit substrat semiconducteur, ladite SRAM comprenant plusieurs paires de cellules unités, chacune desdites paires de cellules unités étant composée d'une première cellule unité (1) et d'une deuxième cellule unité (2), la première cellule unité et la deuxième cellule unité comprenant respectivement un circuit basculeur qui est formé par une paire d'inverseurs chargés par des résistances, chacun desdits inverseurs chargés par des résistances comprenant un transistor inverseur (Q11, Q12, Q21, Q22) composé d'un transistor à effet de champ (FET) qui est formé dans ledit substrat et d'une résistance de charge (R11, R12, R21, R22), où les premières résistances de charge (R11, R21) de ladite première cellule unité (1) et les deuxièmes résistances de charge (R21, R22) de ladite deuxième cellule unité (2) ont un motif de couche respectif qui s'étend par-dessus une surface de substrat d'une cellule unité adjacente à l'intérieur de chacune desdites paires de cellules unités,
caractérisé en ce que lesdites premières résistances de charge (R11, R12) et lesdites deuxièmes resistances de charge (R21, R22) sont formées sur des couches d'isolation différentes (8, 9).

2. Dispositif de mémorisation à accès direct statique à semiconducteur selon la revendication 1, dans lequel :
chacune desdites premières cellules unités (1) comprend en outre une première ligne de source de tension (Vcc1) servant à fournir une tension de source à ladite première cellule unité ; et
chacune desdites deuxièmes cellules unités (2) comprend en outre une deuxième ligne de source de tension (Vcc2) servant à fournir une tension de source à ladite deuxième cellule unité,
où :
lesdites premières résistances de charges (R11, R12) de ladite première cellule unité (1) et ladite première ligne de source de tension (Vcc1) sont formées sur une première couche d'isolation (8) formée par-dessus ledit substrat (7); et
lesdites deuxièmes résistances de charge (R21, R22) de ladite deuxième cellule unité (2) et ladite deuxième ligne de source de tension (Vcc2) sont formées sur une deuxième couche d'isolation (9) qui est formée par-dessus ladite première couche d'isolation (8).

3. Dispositif de mémorisation à accès direct statique à semiconducteur selon la revendication 1, dans lequel :
chacune desdites premières cellules unités (1) comprend en outre une première ligne de source de tension (Vcc1) servant à fournir la tension de source à ladite première cellule unité, et
chacune desdites deuxièmes cellules unités (2) comprend en outre une deuxième ligne de source de tension (Vcc2) servant à fournir la tension de source à ladite deuxième cellule unité,
où :
ladite première ligne de source de tension (Vcc1) est formée sur une première couche d'isolation (8), qui est formée par ledit substrat (7) ;
lesdites premières resistances de charge (R11, R12) de ladite première cellule unité (1) sont formées sur une troisième couche d'isolation (8′) qui est formée par-dessus ladite première couche d'isolation (8) ;
ladite deuxième ligne de source de tension (Vcc2) est formée sur une deuxième couche d'isolation (9), qui est formée par-dessus ladite troisième couche d'isolation (8′) ;
lesdites deuxièmes résistances de charge (R21, R22) de ladite deuxième cellule unité (2) sont formées sur une quatrième couche d'isolation (9′) qui est formée par-dessus ladite deuxième couche d'isolation (9).

4. Dispositif de mémorisation à accès direct statique à semiconducteur selon la revendication 2, dans lequel chacune lesdites cellules unités (1, 2) comprend en outre des transistors de transfert (T11, T12, T21, T22) qui sont chacun connectés à un transistor inverseur respectif, et composés d'un FET formé dans ledit substrat (7) et positionné dans une partie périphérique desdits transistors inverseurs (Q11, Q12, Q21, Q22) afin d'envoyer à un circuit extérieur une information indiquant si ledit inverseur est dans un état haut ou un état bas, où :
les deuxièmes résistances de charge (R21, R22) formées sur ladite deuxième couche d'isolation (9) sont plus longues et plus épaisses que les premières résistances de charge (R11, R12) formées sur ladite première couche d'isolation (8).

5. Dispositif de mémorisation à accès direct statique à semiconducteur selon la revendication 1, 2, 3 ou 4, où ledit substrat (7) est un substrat de silicium, et lesdites couches d'isolation sont des couches de dioxyde de silicium (SiO₂).

6. Dispositif de mémorisation à accès direct statique à semiconducteur selon la revendication 1, 2, 3, ou 4, où lesdites premières et deuxièmes resistances de charge (R11, R12, R21, R22) et lesdites lignes de source de tension (Vcc1, Vcc2) sont faites de silicium polycristallin.

7. Dispositif de mémorisation à accès direct statique à semiconducteur selon la revendication 3 ou 4, où l'épaisseur desdites résistances de charge est inférieure à l'épaisseur desdites lignes de source de tension.

8. Dispositif de mémorisation à accès direct statique à semiconducteur selon la revendication 3, dans lequel lesdites première et deuxième lignes de source de tension (Vcc1, Vcc2) sont chacune formées d'une couche de silicium polycristallin ayant une épaisseur plus grande que celle des premières et deuxièmes résistances de charge (R11, R12, R21, R22), et
ladite SRAM comprend en outre un circuit de protection contre les pointes de courant ou de tension qui est formé à partir de ladite couche de silicium polycristallin possédant une plus grande épaisseur.

9. Dispositif de mémorisation à accès direct statique à semiconducteur selon la revendication 1, dans lequel :
une partie importante du motif de couche des deuxièmes resistances de charge (R21, R22) est formée au-dessus du motif de couche des premières résistances de charge (R11, R12).

10. Dispositif de mémorisation à accès direct statique à semiconducteur selon la revendication 4, dans lequel ladite deuxième ligne de source de tension (Vcc2) est formée à partir d'une couche de silicium polycristallin (15) qui est utilisée pour former lesdites deuxièmes résistances de charge (R21, R22), et
ladite SRAM comprend en outre un circuit de protection contre les pointes de courant ou de tension qui est formé à partie de ladite couche de silicium polycristallin de ladite deuxième ligne de source de tension (Vcc2).
